# EUROPEAN PATENT APPLICATION

(11) **EP 4 570 666 A1**
(43) Date of publication of application: **18.06.2025**
(21) Application number: 23851341.0
(22) Date of filing: 02.06.2023
(51) Int. Cl.: B64D 43/02

(54) **SELF-DRIVING EARLY-WARNING UNIT AND EARLY-WARNING METHOD FOR STALL OF MOVING BODY, AND AIDED DESIGN METHODS**

(30) Priority: 10.08.2022 CN 202210957674; 30.05.2023 CN 202310629289
(71) Applicant: Beijing Institute of Nanoenergy and Nanosystems, Beijing 101400 (CN)
(72) Inventor: XU, Zijie, Beijing 101400 (CN); WANG, Zhonglin, Beijing 101400 (CN); CAO, Nanying, Beijing 101400 (CN); TANG, Wei, Beijing 101400 (CN)
(74) Representative: Stiel, Jürgen
(86) International application number: PCT/CN2023/098090
(87) International publication number: WO 2024/032113

(57) **Abstract**

The present disclosure provides a self-powered early warning unit and early warning method for a stall of a moving body. The early warning unit includes: a triboelectric sensing unit, including a triboelectric electrode layer and a triboelectric layer, wherein the triboelectric electrode layer is attached to a surface of a moving body to be sensed; the triboelectric layer has one end fixed to the triboelectric electrode layer, and the other end, when the moving body does not stall, performing a contact-separation flapping with the triboelectric electrode layer to generate a continuous triboelectric signal; a frequency or voltage of a triboelectric signal decreases or disappears when the moving body stalls; and the triboelectric signal is configured to determine whether the moving body stalls; and/or a piezoelectric sensing unit, configured to be in a sheet structure attached to the triboelectric layer, and generate, when the moving body stalls, different piezoelectric signals with different bending angles of the triboelectric layer, wherein the piezoelectric signal is configured to determine stall degree of moving body. Correspondingly, the present disclosure further provides aided design methods for a component of a moving body and for a vortex generator. The early warning unit is simple in structure, low in cost and excellent in reproducibility.

## Description

### CROSS REFERENCE TO RELATED APPLICATION(S)

This application claims priority to Chinese Patent Application No. 202210957674.5, entitled "Digital testing system and method for stall of aircraft stall based on composite sensing signal", filed on August 10, 2022, and Chinese Patent Application No. 202310629289.2, entitled "Self-powered early warning unit and early warning method for stall of moving body, and aided design methods", filed on May 30, 2023, the entire contents of which are incorporated herein in its entirety by reference.

### TECHNICAL FIELD

The present disclosure relates to a field of stall sensing of a moving body, and in particular, to a self-powered early warning unit, an early warning system and an early warning method for a stall of a moving body, and aided design methods.

### BACKGROUND

A stall warning system of the existing aircraft specifically refers to a device that warns a pilot or ground operator when the aircraft is approaching a stall due to a change in angle of attack, and consists of an angle of attack sensor, a Mach sensor, a flap position sensor, a stall warning controller and an alarm device. An instantaneous angle of attack of the aircraft is measured by the angle of attack sensor, and a signal is input into the stall warning controller for comparison with a predetermined value of a stall warning angle of attack. This predetermined value is related to the Mach number and the flap position. When the instantaneous angle of attack of the aircraft is greater than the stall warning angle of attack, the alarm device is turned on and an alarm signal is sent to the pilot or ground operator. Although the device has excellent accuracy, it has the disadvantages of being expensive and complicated. Moreover, it is difficult to install an expensive stall warning system during the design and experimental stage of an aircraft to reduce the high expenses in the design stage.

Meanwhile, in addition to manned aircraft, the market of unmanned aerial vehicles is expanding. However, in the existing art, a stall warning system of manned aircraft could not be installed on the unmanned aerial vehicle due to cost factors, which has a great impact on the flight safety of unmanned aerial vehicles.

### SUMMARY

In order to overcome the problems in the existing stall warning technology, a technology that combines a triboelectric signal of a triboelectric nanogenerator (TENG) with a piezoelectric signal is adopted in the present disclosure. The triboelectric signal or a triboelectric-piezoelectric signal is used to perform a self-powered early warning of a stall of a moving body such as an aircraft (manned or unmanned), and perform a self-powered cancellation of the early warning after a recovery of the stall.

The present disclosure provides a self-powered early warning unit for a stall of a moving body, including: a triboelectric sensing unit, including a triboelectric electrode layer and a triboelectric layer, wherein the triboelectric electrode layer is a flexible layer attached to a surface of a moving body to be sensed; the triboelectric layer is an elastic structure, one end of the triboelectric layer is fixed to the triboelectric electrode layer, and the other end of the triboelectric layer is configured to, when the moving body does not stall, perform a contact-separation flapping with the triboelectric electrode layer to generate a continuous triboelectric signal; a frequency or voltage of the triboelectric signal decreases or disappears when the moving body stalls; and the triboelectric signal is configured to determine whether the moving body stalls; and/or a piezoelectric sensing unit, configured to be in a sheet structure attached to the triboelectric layer, and generate, when the moving body stalls, different piezoelectric signals with different bending angles of the triboelectric layer, wherein the piezoelectric signal is configured to determine a stall degree of the moving body. Furthermore, an early warning system is formed by a plurality of the above warning units arranged in an array.

Correspondingly, the present disclosure further provides a self-powered early warning method for a stall, by using the above early warning unit or the above early warning system for a stall, including: determining that a moving body does not stall, when the triboelectric sensing unit generates a continuous triboelectric signal; performing an early warning of a stall of the moving body, when a frequency of the triboelectric signal decreases or disappears; and/or determining a stall degree of the moving body according to piezoelectric signals generated by the piezoelectric sensing unit at different bending angles of the triboelectric layer.

Compared with the related art, the technology of the present disclosure has the following advantages:
The early warning unit and the early warning method of the present disclosure accurately perform a stall warning and cancel the warning after eliminating the stall by utilizing a reverse airflow generated by airflow separation at the rear end of the wing when a moving body such as an aircraft (a manned fixed-wing aircraft and an unmanned aerial vehicle) stalls.

A triboelectric signal is used to accurately measure airflow separation during a stall, and a piezoelectric signal is used to accurately measure a stall degree after the stall of the airflow separation.

A triboelectric-piezoelectric signal in the early warning method is used, together with CFD simulation analysis, to assist in optimizing the design of components of a moving body such as fixed-wings in the flight design phase.

The triboelectric-piezoelectric signal in the early warning method is used, together with CFD simulation analysis, to assist in optimizing a vortex generator in the design phase.

An ultra-thin metal foil material such as a patch is used for the triboelectric electrode layer of the triboelectric sensing unit to solve the problem of reproducibility of a surface of a moving body such as an airplane, and a flexible and lightweight triboelectric or piezoelectric signal test patch is used to solve the problem of the weight of the device.

Meanwhile, in the present disclosure, finite element simulation of a CFD wing model may be used, together with a reproducible digital stall early warning system and early warning method for an aircraft, to repeatedly modify and improve components of a moving body such as an airfoil of wings of an aircraft in the design phase, and devices such as a vortex generator, without the need to use the existing complex stall sensing system, thereby greatly reducing flight research and development costs.

Compared with the existing sensor devices, the early warning unit and system of the present disclosure are simple in structure, low in cost, excellent in reproducibility, and may be more accurately attached to a variety of complex wing surfaces.

### BRIEF DESCRIPTION OF THE DRAWINGS

The accompanying drawings are used to provide further understanding of the present disclosure and constitute a part of the specification. Together with the following specific embodiments, they are used to explain the present disclosure, but do not constitute a limitation of the present disclosure. In the accompanying drawings:
FIG.1 is a schematic diagram showing a structure of a self-powered early warning unit for a stall of a moving body of the present disclosure;
FIG. 2 is a working principle diagram showing the self-powered early warning unit for a stall of a moving body of the present disclosure; and
FIG. 3 shows a test result of a piezoelectric signal of the self-powered early warning unit for a stall of a moving body.

### DETAILED DESCRIPTION OF EMBODIMENTS

The specific embodiments of the present disclosure will be described in detail below with reference to the accompanying drawings. It should be understood that the specific embodiments described herein are only used to illustrate and explain the present disclosure, and are not used to limit the present disclosure.

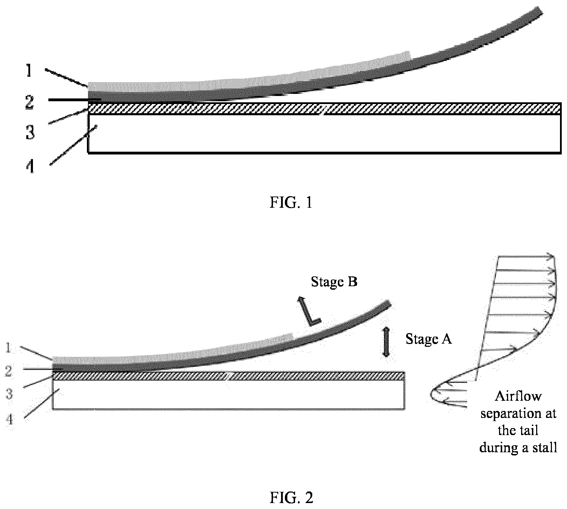

A stall of an aircraft (or a moving body) refers to a situation in which an airplane or a wing operates at an angle of attack greater than the maximum lift angle of attack, and is characterized by airflow separation and control failure. When a lift generated by the aircraft as it moves forward is less than the gravity it is subject to, the aircraft will descend or crash, resulting in a stall at a high angle of attack stall. The reason for the stall of the aircraft is that the airflow separation occurs at a high angle of attack. As shown in FIG. 2, when the angle of attack of the aircraft is higher than a certain angle, the airflow at the rear end of the aircraft will no longer flow along the wing surface due to the separation effect, causing the lift of the aircraft to suddenly drop significantly. At the same time, a reverse reaction turbulence will be generated at the rear end of the wings of the aircraft, and these reverse forces will also reduce the lift of the aircraft and cause stall. The emergence of technologies of angle of attack monitoring, angle of attack limitation, and anti-spin (spiral) control has brought the flight control technology to an advanced level with better control. However, the development of flight control technology may not completely solve the stall problem. After all, flight is not an independent activity of an aircraft, and environmental factors and human factors are still the most critical factors affecting the flight safety. In the present disclosure, a technology that combines a triboelectric nano-generation signal with a piezoelectric sensing signal is used, in which a triboelectric-piezoelectric signal is used to perform a self-powered early warning for a stall of an aircraft (manned or unmanned), and perform a self-powered early warning cancellation after recovery of the stall. The present disclosure will be described in detail below with reference to the specific embodiments.

self-poweredA self-powered early warning unit for a stall of a moving body provided by the embodiment includes a triboelectric sensing unit and a piezoelectric sensing unit. A typical structure is shown in FIG. 1. The triboelectric sensing unit includes a triboelectric electrode layer 3 and a triboelectric layer 2. The triboelectric electrode layer 3 is a flexible layer attached to a surface of a moving body 4 to be sensed. The triboelectric layer 3 is an elastic structure, one end of the triboelectric layer 3 is fixed to the triboelectric electrode layer 3, and the other end of the triboelectric layer 3 is configured to, when the moving body 4 does not stall, perform a contact-separation flapping with the triboelectric electrode layer 3 to generate a continuous triboelectric signal. A frequency or voltage of the triboelectric signal decreases or disappears when the moving body 4 stalls. Triboelectric signal is related to whether the moving body stalls, and may be used to determine whether the moving body stalls and determine a stall degree. The piezoelectric sensing unit 1 is in a sheet structure attached to the triboelectric layer 2, and generates, when the moving body 4 stalls, different piezoelectric signals with different bending angles of the triboelectric layer 2. The piezoelectric signal is used to determine a stall degree of the moving body 4.

The triboelectric sensing unit and the piezoelectric sensing unit together construct a flexible triboelectric-piezoelectric composite sensing unit.

The self-powered early warning unit for a stall of a moving body of the embodiment further may also include an alarm unit (not shown in the accompanying drawings) used to receive the triboelectric signal and the piezoelectric signal, and determine a stall state. No stall occurs, when the triboelectric signal is a continuous signal. The alarm unit emits an early warning of a stall, when a value of the voltage or frequency of the triboelectric signal is lower than a set value. Alternatively, the alarm unit emits a serious stall signal, when the triboelectric signal disappears. Alternatively, the alarm unit emits a complete stall signal, when the piezoelectric signal appears.

The moving body to be sensed in the embodiment may be an aircraft, such as a fixed-wing aircraft or an unmanned aerial vehicle, or may be an automobile, a ship, or a vessel.

Specifically, in the embodiment, the moving body 4 to be sensed is an aircraft as an example, and a metal foil electrode, such as a copper foil and gold foil is used as the triboelectric electrode layer 3, and attached to a rear end of the aircraft (e.g., a wing of an airplane). The size of the triboelectric electrode layer 3 has no effect on the performance of the triboelectric sensing unit. In order to be closely attached to the surface of the moving body 4 to be sensed, such as a wing, a thickness may range between 0.01 mm and 0.5 mm. A metal copper foil electrode may have a size of 1.5 cm in width and 10 cm in length, and has the performance of being closely conformal to the surface of the aircraft.

In the triboelectric sensing unit, the triboelectric electrode layer 3 serves as a contact layer, which is also called a conductive layer, with the triboelectric layer. The copper foil has a thickness of 100 microns, a length of 10 cm and a width of 1 cm. The copper foil is connected to wings of the aircraft by a 3M high-viscosity adhesive.

The triboelectric layer 2 is of an elastic structure, and may contact and separate with the triboelectric layer 3 under a turbulence at the tail of the aircraft to generate a triboelectric signal. The triboelectric layer 2 may be made of a polymer film, such as a polymer film of FEP (fluorinated ethylene propylene), and have a length of 10 cm and a width of 1 cm. One end of the triboelectric layer 2 (the left side in FIG. 1) is connected with a left head of the triboelectric electrode layer 3 through a 3M double-sided tape (with a thickness of 1 mm). The other end (the left side in FIG. 1) is a free end, and may freely flap the triboelectric electrode layer 3 under a driving force, which is a surface turbulence during the flight of the aircraft. The triboelectric layer 2 and the triboelectric electrode layer 3 perform a contact-separation flapping, so that a continuous triboelectric signal is generated when the aircraft does not stall.

The triboelectric layer of the embodiment may also be a triboelectric dielectric layer of a flexible triboelectric nanogenerator TENG with excellent performance, for example, a film of a polymer, such as PDMS (polydimethylsiloxane), PU (polyurethane), PET (polyethylene terephthalate), and PI (polyimide), a cellulose film, or the like.

An electrode connected with the triboelectric electrode layer 3 may include a metal electrode, a carbon-based electrode, a polymer conductive electrode, a nanowire electrode, and the like.

It may be seen from the working principle of the early warning unit in the above embodiment that the triboelectric signal generated by the triboelectric sensing unit and the piezoelectric signal of the piezoelectric sensing unit may independently reflect the stall state of the moving body. Therefore, in other embodiments, the self-powered early warning unit for a stall may only include the above triboelectric sensing unit, or only include the above piezoelectric sensing unit.

The piezoelectric sensing unit 1 is of a sheet structure, which may be a stacked structure of a piezoelectric material patch and a conductive electrode. For example, the piezoelectric material patch may be a commercial PVDF piezoelectric film with a thickness of 100 microns, and the conductive electrode may be a silver electrode deposited by magnetron sputtering with a thickness of 28 microns, a length of 5 cm and a width of 1 cm. In order to better sense a bending degree of the triboelectric layer 2, the piezoelectric patch is attached to the triboelectric electrode layer 2 at a position 5 cm from a fixed end (the left side in FIG. 1). After the aircraft stalls, the stall degree of the aircraft may be determined through the piezoelectric signals at different bending angles.

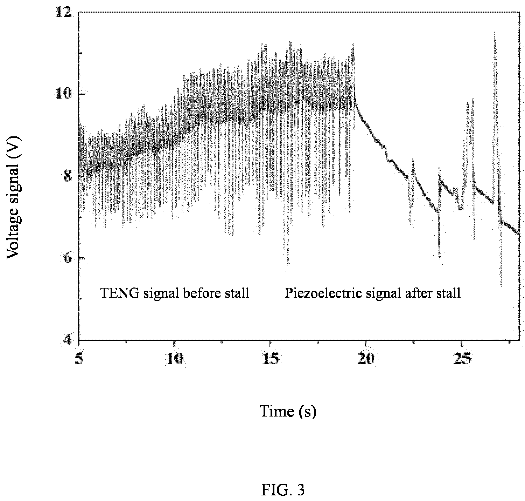

In conjunction with FIG. 1 to FIG. 3, triboelectric signal sensing data of stage A may be obtained by constructing a complete and reproducible early warning unit for a stall. By analyzing the triboelectric signal sensing data, after a reverse airflow separation force is generated at a moving body, such as a rear end of an aircraft wing, a flapping frequency of the triboelectric layer will gradually decrease. When the flapping frequency decreases to a certain level (for example, after an AC voltage amplitude of the triboelectric signal drops to a ±1 V range), the triboelectric layer begins to bend in a reverse direction, and at this time, the triboelectric signal disappears. When the flapping frequency of the triboelectric layer 2 gradually decreases, an early warning of a stall may be emitted. When the triboelectric signal disappears, a serious stall may be signaled. When the triboelectric layer begins to bend in the reverse direction and the piezoelectric sensing unit starts to operate and generate a piezoelectric signal, a complete stall may be signaled. In this case, a failure to recover the stall will greatly impact the safety of the aircraft.

A technology that combines a triboelectric nano-generation signal with a piezoelectric sensing signal is used in the present disclosure. A triboelectric-piezoelectric signal is used to perform a self-powered early warning of a stall process of an aircraft (manned or unmanned). This may help a pilot or an operator to recover the stall, and perform a self-powered early warning cancellation after the stall is recovered. At this time, the triboelectric signal is restored, so that the aircraft may fly normally again.

The triboelectric sensing unit, the piezoelectric sensor unit and the alarm unit constitute a reproducible digital early warning system for a stall of an aircraft.

In another embodiment of the present disclosure, a self-powered early warning method for a stall of a moving body is further provided. As shown in FIG. 2, the digital early warning system for a stall provided in the above embodiment is used, the moving body 4 to be sensed is an aircraft, and the triboelectric electrode layer 3 is a metal foil electrode, which performs a contact-separation flapping with the triboelectric layer 2 and generates a continuous triboelectric signal, thereby determining that the aircraft does not stall. The piezoelectric material patch of the piezoelectric sensing unit 1 may determine the stall degree of the aircraft through the piezoelectric signals at different bending angles after the stall, and may perform an accurate sensing and early warning of a stall of the aircraft by using the triboelectric-piezoelectric composite sensing signal. This process may be divided into two stages. In stage A (indicated by the arrow in FIG. 2), in a case where a stall does not occur, the triboelectric layer 2 generates a triboelectric signal due to flapping of the triboelectric electrode layer 3 up and down by a weak turbulence. In stage B (indicated by the arrow in FIG. 2), in a case where a stall occurs, the elastic triboelectric layer 2 bends upward, the frequency of the triboelectric signal decreases and disappears, and an early warning of a stall may be performed. In the embodiment, when the triboelectric signal decreases to be within a range of ±1V, an early warning of a stall warning is initiated. After the stall occurs, the bending degree is sensed by the piezoelectric material patch, and the piezoelectricity indicates the stall degree. In the embodiment, when a piezoelectric signal is generated, a stall occurs, and when the piezoelectric signal is greater than a set value such as 4V, the stall is determined to be a serious stall.

Meanwhile, in other embodiments, an array of the above early warning units may be used. A plurality of early warning units are arranged in an array on the surface of the aircraft (moving body), for example, the triboelectric-piezoelectric composite self-powered early warning units are spread horizontally and longitudinally on the wing surface, so as to constitute a complete and reproducible digital early warning system for an aircraft.

The present disclosure further provides an aided design method for a component of a moving body (such as a wing of an aircraft). The aircraft is under a test environment, such as a wind tunnel. A continuous triboelectric signal is generated, when the aircraft does not stall. A stall degree may be determined through a piezoelectric signal, after the aircraft stalls. A design of the component of the moving body is repeatedly modified according to a test result.

The present disclosure further provides an aided design method for a vortex generator. The vortex generator is under a test environment, and uses the above self-powered early warning method for a stall. A continuous triboelectric signal is generated, when the vortex generator does not stall. A stall degree is determined through a piezoelectric signal after the vortex generator stalls. A design of the vortex generator is repeatedly modified according to a test result.

The above test environment may include an atmospheric test and a wind tunnel test, and gas may include air, oxygen, nitrogen, argon and the like.

With the aided design method of the embodiment, the triboelectric-piezoelectric composite sensing signal may be used to perform an accurate sensing and early warning of a stall of an aircraft, and perform an aided design of a component of a moving body.

Meanwhile, in the aided design method of the embodiment, an array of a plurality of early warning units may be used to perform a multi-channel early warning, spread the triboelectric-piezoelectric composite early warning units horizontally and longitudinally on the wing surface of the aircraft, and constitute a complete and reproducible digital early warning system for a stall of an aircraft.

Meanwhile, the above reproducible aided design method for a component of a moving body such as an aircraft may be used in combination with a finite element simulation of a CFD wing model by using the above self-powered early warning method for a stall, so as to perform an aided design of an airfoil, a vortex generators and other devices of the aircraft in the design stage. Repeated modifications and improvements may be made without the need to use the existing complex stall sensing system, thereby greatly reducing the cost of flight research and development. In the embodiment, CFD simulation software is Ansys Fluent 2012 software.

In a specific example of the embodiment, a wing section of a model Cessna 182 aircraft is used as a test carrier of a wing section of the aircraft, wings of the Cessna 182 aircraft are also selected for the finite element simulation of CFD simulation, and the wind tunnel is a professional-grade wind tunnel with backflow necking, which may generate a maximum wind speed of 80 m/s. A test section of the wind tunnel is 1 m in length, 50 cm in width, and 50 cm in height.

In the present disclosure, the composite sensing signal of the piezoelectric signal and the triboelectric signal is obtained by testing using a Keithley 6514 electric meter, the electric signal is an open circuit voltage signal, and the Keithley 6514 electric meter is connected with the early warning unit for a stall in the wind tunnel through an ultra-fine wire. A specific test result is shown in figure.

The aided design method of the embodiment may be used for, including but not limited to, an early warning of a stall of an airplane, and it may be also used for an automobile streamline design, and a design optimization of a component of various moving bodies, such as an unmanned aerial vehicle, an aircraft, a ship and a vessel.

It should also be noted that the various specific technical features described in the above specific embodiments may be combined in any suitable manner without contradiction. In order to avoid unnecessary repetition, various possible combinations will not be further explained in the present disclosure. In addition, various embodiments of the present disclosure may be arbitrarily combined, and as long as they do not violate the concept of the present disclosure, they should also be regarded as the contents disclosed by the present disclosure.

## Claims

1. A self-powered early warning unit for a stall of a moving body, comprising:
a triboelectric sensing unit, comprising a triboelectric electrode layer and a triboelectric layer, wherein the triboelectric electrode layer is a flexible layer attached to a surface of a moving body to be sensed; the triboelectric layer is an elastic structure, one end of the triboelectric layer is fixed to the triboelectric electrode layer, and the other end of the triboelectric layer is configured to, when the moving body does not stall, perform a contact-separation flapping with the triboelectric electrode layer to generate a continuous triboelectric signal; a frequency or voltage of the triboelectric signal decreases or disappears when the moving body stalls; and the triboelectric signal is related to whether the moving body stalls; and/or,
a piezoelectric sensing unit, configured to be in a sheet structure attached to the triboelectric layer, and generate, when the moving body stalls, different piezoelectric signals with different bending angles of the triboelectric layer, wherein the piezoelectric signal is configured to determine a stall degree of the moving body.

2. The early warning unit according to claim 1, further comprising an alarm unit configured to receive the triboelectric signal and the piezoelectric signal, and determine a stall state,
wherein no stall occurs when the triboelectric signal is a continuous signal; the alarm unit is configured to emit an early warning of a stall when a voltage value or frequency of the triboelectric signal is lower than a set value; or the alarm unit is configured to emit a serious stall signal when the triboelectric signal disappears; or the alarm unit is configured to emit a complete stall signal when the piezoelectric signal appears.

3. The early warning unit according to claim 1 or 2, wherein the triboelectric electrode layer is a metal foil; and the triboelectric electrode layer has a thickness ranging from 0.01 mm to 0.5 mm.

4. The early warning unit according to any one of claim 1 to claim 3, wherein the triboelectric layer is a polymer film; and the polymer film is a FEP film, a PDMS film, a PU film, a PET film, a PI film or a cellulose film.

5. The early warning unit according to any one of claim 1 to claim 4, wherein the moving body to be sensed is a manned fixed-wing aircraft, an unmanned aerial vehicle, an automobile, an aircraft or a ship; and the triboelectric electrode layer is disposed on a surface of a rear end of the moving body.

6. An early warning system for a stall, comprising the self-powered early warning unit for a stall of a moving body according to any one of claim 1 to claim 5, wherein a plurality of warning units are arranged in an array on a surface of the moving body.

7. A self-powered early warning method for a stall, by using the early warning unit according to any one of claim 1 to claim 5 or the early warning system for a stall according to claim 6, comprising: determining that a moving body does not stall, when the triboelectric sensing unit generates a continuous triboelectric signal; performing an early warning of a stall of the moving body, when a frequency of the triboelectric signal decreases or disappears; and/or determining a stall degree of the moving body according to piezoelectric signals generated by the piezoelectric sensing unit at different bending angles of the triboelectric layer.

8. The early warning method according to claim 7, further comprising: emitting an early warning of a stall, when the piezoelectric signal is generated; or determining the stall as a serious stall, when a voltage value of the piezoelectric signal is higher than a set voltage value.

9. The early warning method according to claim 8, wherein the set voltage value is 4 V.

10. The early warning method according to any one of claim 7 to claim 9, further comprising: emitting an early warning of a stall, when a voltage value of the triboelectric signal is lower than a set voltage value.

11. The early warning method according to claim 10, wherein the set voltage value is 1 V.

12. The early warning method according to any one of claim 7 to claim 11, further comprising: performing a self-powered cancelation of the early warning, after a recovery of the stall of the moving body.

13. An aided design method for a component of a moving body, comprising: when the component of the moving body is under a test environment, by using the self-powered early warning method for a stall according to any one of claim 7 to claim 11, generating a continuous triboelectric signal when the component of the moving body does not stall; determining a stall degree through a piezoelectric signal after the moving body stalls; and repeatedly modifying a design of the component of the moving body according to a test result.

14. The aided design method according to claim 13, wherein the moving body is an automobile, an unmanned aerial vehicle, an aircraft, a ship or a vessel.

15. An aided design method for a vortex generator, comprising: when the vortex generator is under a test environment, by using the self-powered early warning method for a stall according to any one of claim 7 to claim 11, generating a continuous triboelectric signal when the vortex generator does not stall; determining a stall degree through a piezoelectric signal after the vortex generator stalls; and repeatedly modifying a design of the vortex generator according to a test result.

16. The aided design method according to claim 13 or claim 15, wherein a plurality of early warning units according to claim 1 to claim 5 are arranged in an array.

17. The aided design method according to claim 13 or claim 15, wherein the test environment is an atmospheric test or a wind tunnel test, and a gas used is air, oxygen, nitrogen or argon.
